# FASCICULE DE BREVET EUROPEEN

(11) **EP 0 403 335 B1**
(45) Date de publication et mention de la délivrance du brevet: **01.09.1993**
(21) Numéro de dépôt: 90401542.7
(22) Date de dépôt: 06.06.1990
(51) Int. Cl.: H05K 3/20

(54) **Procédé de fabrication d'un boîtier pour circuit électronique et boîtier pour circuit électronique obtenu selon ce procédé notamment pour véhicule automobile**
Verfahren zur Herstellung eines Gehäuses für eine elektronische Schaltung, ein derartiges Gehäuse, insbesondere für Kraftfahrzeuge, das nach diesem Verfahren hergestellt wurde
Method of fabrication of a case for electronic circuits and such a case, especially for motor vehicles, obtained by this method

(30) Priorité: 07.06.1989 FR 8907555
(43) Date de publication de la demande: 19.12.1990
(73) Titulaire: AUTOMOBILES PEUGEOT, 75116 Paris (FR); AUTOMOBILES CITROEN, 92200 Neuilly-sur-Seine (FR)
(72) Inventeur: Celnik Jean, F-75013 Paris (FR)
(74) Mandataire: Moncheny, Michel

(56) Documents cités:
- EP-A- 0 305 267
- WO-A-87/01557
- US-A- 3 655 496

## Description

La présente invention concerne un procédé de fabrication d'un boîtier pour circuit électronique et un boîtier pour circuit électronique obtenu selon ce procédé, notamment pour véhicule automobile.

Le développement de l'électronique dans l'industrie automobile et le manque de place disponible dans les véhicules, conduisent souvent à intégrer les boîtiers pour circuit électronique aux organes de commande ou à commander de celui-ci.

Ce concept implique l'utilisation de boîtiers présentant des formes adaptées aux applications, c'est à dire des boîtiers en trois dimensions qui ne soient plus de forme parallélépipèdique.

Dans la terminologie utilisée par la suite, on considère qu'un circuit comprend un substrat sur lequel est déposée une circuiterie d'interconnexion des composants. Le substrat recevant la circuiterie d'interconnexion des composants électroniques peut être plat, c'est à dire en deux dimensions, et comparable à un circuit imprimé classique ou avoir une forme particulière en trois dimensions permettant son association à un organe particulier du véhicule.

La circuiterie épouse quant à elle la forme du substrat et est donc en deux ou trois dimensions selon les applications.

Les modes de report et de brasage des composants dans des technologies éprouvées imposent pour les boîtiers pour circuit électronique, une circuiterie en deux dimensions, tandis que l'intégration du boîtier à l'organe de commande ou à commander du véhicule, dans des formes géométriques variées, impose un substrat en trois dimensions.

Par ailleurs, les applications dans le domaine de l'industrie automobile demandent certaines performances spécifiques, à savoir :
- une intégration de la connectique au substrat;
- la fixation du boîtier sur l'organe de commande ou à commander du véhicule;
- un dispositif permettant un refroidissement par conduction dans le cas de boîtiers de puissance.

Ces différentes performances peuvent être obtenues par des technologies de moulage de boîtiers associant des inserts.

C'est pourquoi l'invention concerne notamment des circuits en trois dimensions comportant une circuiterie en deux dimensions associée à un substrat en trois dimensions utilisant des boîtiers obtenus par moulage et comportant des inserts métalliques.

Dans les techniques classiques, la circuiterie est obtenue en deux étapes, à savoir l'imageage et la métallisation.

L'opération d'imageage sur le substrat consiste à définir la topologie de la circuiterie qui devra être réalisée. Cette topologie est obtenue par des caches qui, selon les procédés de fabrication utilisés, sont déposés par sérigraphie ou révélés par des procédés photographiques sur le substrat.

Pour des définitions moyennes de 300 à 400 microns de gravure, la sérigraphie de vernis répond aux besoins tandis que pour des définitions de gravure plus précises, le dépôt de films secs ou liquides photosensibles est nécessaire.

L'utilisation de vernis photosensibles pouvant être traités par sérigraphie, permet également d'obtenir des circuits à haute définition.

Dans tous les cas de figure, l'opération d'imageage est une opération unitaire car on travaille directement sur un substrat. Cette opération peut faire appel à des procédés automatiques. Cependant, on ne peut travailler que sur un seul substrat à la fois et il est donc difficile d'améliorer les cadences de production des boîtiers.

Les procédés de métallisation du substrat se classent en deux familles, à savoir les méthodes additives et les méthodes soustractives.

La méthode additive consiste à métalliser par croissance électrolytique, du cuivre sur les zones du substrat non recouvertes par le vernis déposé dans la phase d'imageage.

On peut également inclure dans la méthode additive, les procédés de sérigraphie d'encres conductrices définissant la circuiterie.

Dans ce cas de figure, l'imageage se fait par un écran de sérigraphie.

La méthode soustractive consiste à éliminer le matériau conducteur non protégé par le vernis de l'imageage.

Cependant, tous ces procédés présentent un certain nombre d'inconvénients dans la mesure où comme on l'a mentionné précédemment, on travaille directement sur le substrat et on ne peut donc réaliser qu'un seul boîtier à la fois d'où il résulte des prix de revient relativement élevés.

Le but de l'invention est donc de résoudre ces problèmes en proposant un procédé de fabrication d'un boîtier pour circuit électronique qui soit simple, fiable, pouvant être largement automatisé et autorisant une cadence de fabrication très élevée.

Par ailleurs, le procédé suivant l'invention a également pour but de réaliser les opérations d'imageage et de métallisation par des procédés mécaniques à très haute productivité.

A cet effet, l'invention a pour objet un procédé de fabrication d'un boîtier pour circuit électronique du type comportant un substrat, une circuiterie d'interconnexion de composants électroniques, des moyens de connexion électrique et des moyens de fixation de ce boîtier sur un support de forme quelconque, caractérisé en ce que la circuiterie d'interconnexion des composants est réalisée indépendamment du substrat en opérant une première découpe d'une feuille de matériau conducteur pour obtenir une ébauche de circuiterie, en fixant cette ébauche de circuiterie sur une feuille de matériau isolant, en opérant une deuxième découpe de cette ébauche et de cette feuille de matériau isolant pour obtenir la circuiterie d'interconnexion finale et enfin, en fixant cette circuiterie sur le substrat.

Avantageusement, les feuilles de matériaux conducteur et isolant se présentent sous la forme de bandes dans lesquelles sont pratiqués lors de la première opération de découpe, des trous d'indexation de position, d'entraînement de bandes, ainsi que des découpes fonctionnelles déterminant, dans la feuille de matériau conducteur, des portions conductrices, et dans la feuille de matériau isolant, des portions d'exposition de parties de la circuiterie.

Avantageusement également, la fixation de l'ébauche de circuiterie sur la feuille de matériau isolant et la fixation de la circuiterie finale sur le substrat, sont réalisées par collage.

L'invention sera mieux comprise à l'aide de la description qui va suivre, donnée uniquement à titre d'exemple et faite en se référant aux dessins annexés, sur lesquels :
- la Fig.1 représente un exemple d'intégration d'un boîtier pour circuit électronique en trois dimensions, sur un organe de commande ou à commander d'un véhicule automobile;
- la Fig.2 représente un organigramme illustrant différentes étapes d'une première partie d'un procédé selon l'invention;
- les Fig.3A, 3B, 3C illustrent trois étapes d'un procédé selon l'invention, pour la fabrication d'une circuiterie pour un boîtier pour circuit électronique;
- la Fig.4 représente un organigramme illustrant différentes étapes d'une seconde partie d'un procédé selon l'invention ; et
- la Fig.5 représente un organisme illustrant différentes étapes d'une troisième partie d'un procédé selon l'invention.

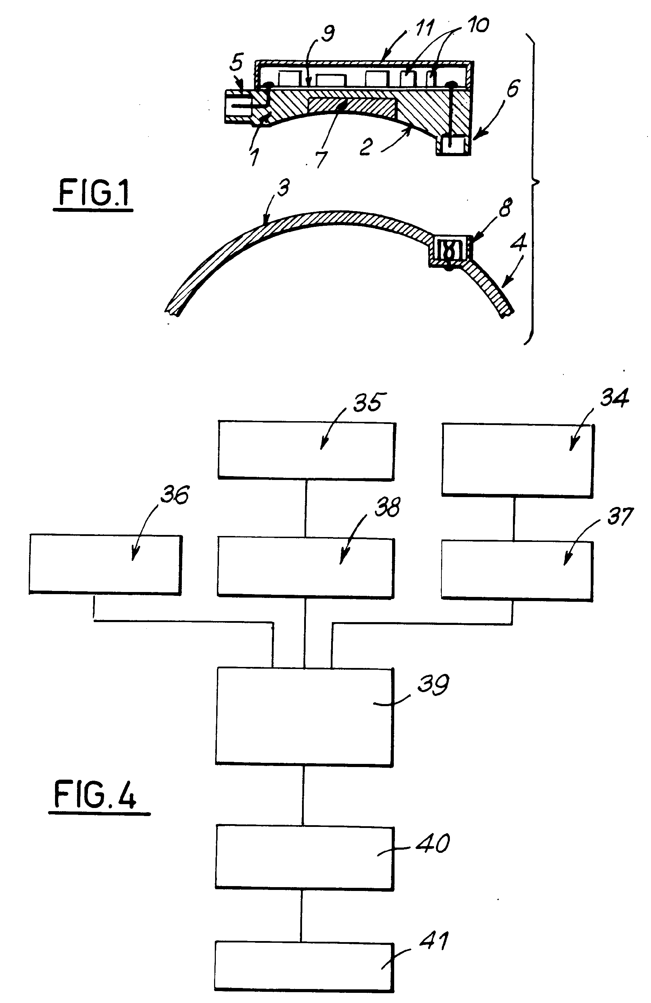

Ainsi qu'on peut le voir sur la Fig. 1, qui représente un exemple de réalisation d'un boîtier pour circuit électronique obtenu par un procédé de fabrication selon l'invention, celui-ci comporte un substrat 1 constitué par exemple par la partie de fond du boîtier, présentant une face inférieure 2 de forme complémentaire à celle d'une surface extérieure 3 d'un organe de commande ou à commander 4 d'un véhicule automobile, sur lequel doit être monté ce boîtier pour circuit électronique.

Ce substrat 1 comporte un certain nombre d'inserts métalliques entrant dans la constitution par exemple de connecteurs d'entrée et de sortie respectivement 5 et 6, et d'un dissipateur thermique 7.

Le connecteur d'entrée 5 permet de relier les composants électroniques de ce boîtier au reste des circuits du véhicule, tandis que le connecteur de sortie 6 est adapté pour coopérer avec un connecteur de raccordement 8 de l'organe de commande ou à commander, pour la transmission des informations entre le boîtier et l'organe.

Ces connecteurs 5 et 6 sont reliés à une circuiterie d'interconnexion de composants 9 diposée sur le substrat, dont le procédé de fabrication sera décrit plus en détail par la suite, et sur laquelle sont déposés des composants électroniques 10.

Le boîtier est également muni d'un couvercle de protection 11.

Ce substrat peut être réalisé en tout matériau approprié, comme par exemple en matière plastique ou autre, supportant les différentes contraintes liées à une utilisation dans un environnement automobile. L'ensemble de boîtier peut par exemple être obtenu par moulage.

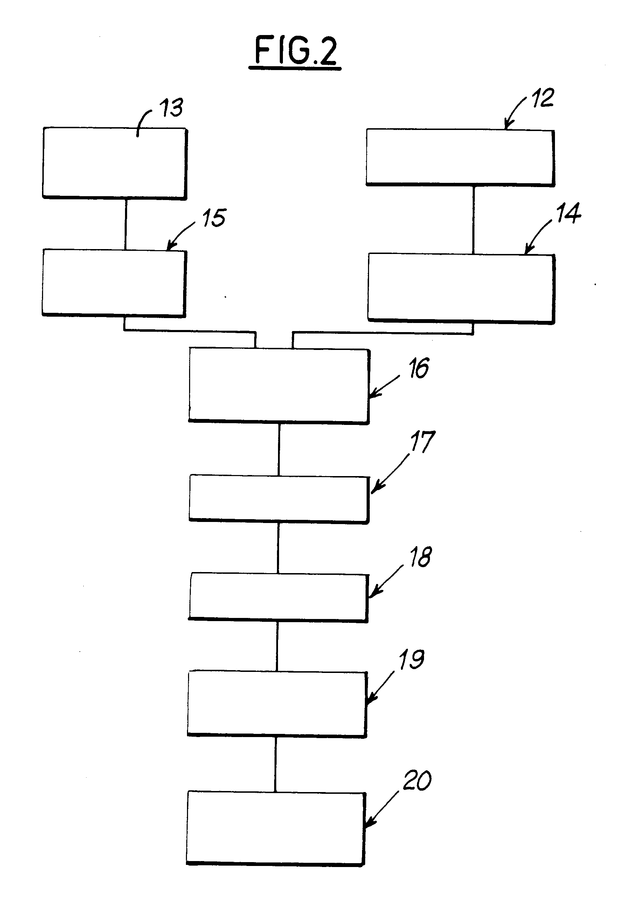

Si l'on se reporte maintenant à la Fig.2 qui représente un organigramme illustrant une première partie d'un procédé de fabrication selon l'invention, en 12 et 13, sont représentées deux étapes initiales du procédé de fabrication, dans lesquelles, par exemple en 12, un matériau conducteur est stocké par exemple sous forme de bandes, en rouleau. Ce matériau conducteur peut être constitué par du cuivre, du nickel ou un autre matériau.

En 13, une bande de matériau isolant se présente également sous forme de bande, en rouleau, ce matériau isolant étant constitué de tout matériau approprié.

Lors des étapes 14 et 15, sont prévues des premières opérations de découpe respectivement des bandes de matériau conducteur et de matériau isolant pour former dans ces bandes de matériau, d'une part, une ébauche de circuiterie ainsi que des trous d'indexation de position et d'entraînement de bande pour le matériau conducteur, et d'autre part, des trous d'indexation de position et d'entraînement de bande ainsi que des portions d'exposition de parties de la circuiterie, qui seront décrites plus en détail par la suite, pour le matériau isolant.

Les feuilles de matériau conducteur et de matériau isolant sont ensuite collées l'une sur l'autre, par exemple dans l'étape 16, ce collage étant réalisé par exemple par passage entre deux rouleaux chauffants.

Après cette étape de collage 16, est prévue une étape de découpe 17 lors de laquelle est opérée une découpe finale à la fois de l'ébauche de circuiterie et de la feuille de matériau isolant pour obtenir la circuiterie d'interconnexion finale qui est mise en rouleau à l'étape 18, polymérisée en 19 et enfin stockée en 20.

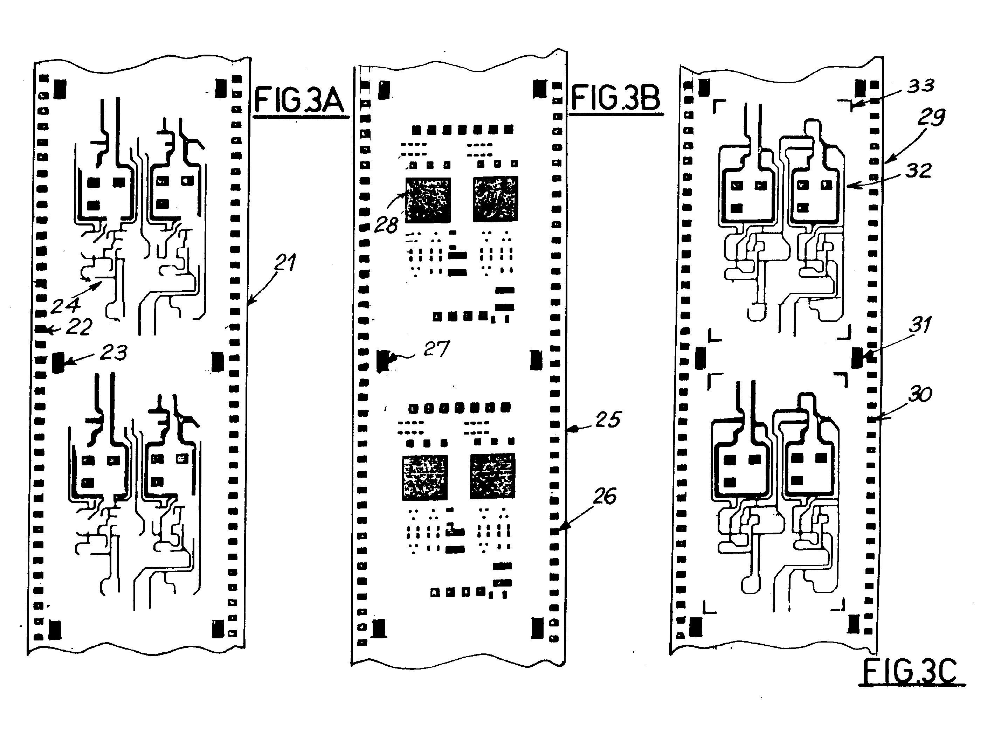

Comme on peut le voir sur la figure 3A, qui représente une bande de matériau conducteur 21 après passage dans la première étape de découpe, c'est à dire après l'étape 14 décrite en regard de la Fig.2, celle-ci comporte des trous 22 d'entraînement de la bande de matériau conducteur, des trous 23 d'indexation de position permettant lors du collage de repérer les positions relatives de la bande de matériau conducteur et de la bande de matériau isolant pour leur fixation, et enfin des découpes 24 déterminant une ébauche de circuiterie.

Sur la Fig.3B, on a représenté une bande 25 de matériau isolant. Cette bande 25 comporte également des trous d'entrainement 26, des trous d'indexation de position 27 ainsi que des découpes 28 permettant d'exposer des parties de la circuiterie, par exemple pour la connexion de celles-ci aux connecteurs d'entrée et de sortie ou autres.

Dans un premier temps ces deux bandes de matériaux conducteur et isolant sont donc traitées séparément et, dans un deuxième temps, amenées dans un poste de collage dans lequel la bande de matériau conducteur et la bande de matériau isolant, prédécoupées, sont fixées l'une sur l'autre par exemple par collage avant leur passage dans une nouvelle étape de découpe dont le résultat est représenté sur la Fig.3C. Cette Fig. 3C représente une bande d'éléments de circuiterie 29 présentant des trous 30 d'entraînement de la bande, des trous d'indexation de position 31, des éléments de circuiterie complète 32 obtenus après la seconde découpe des bandes décrites en regard des Fig.3A et 3B, et enfin des ébauches de rupture 33 permettant de séparer les éléments de circuiterie du reste de la bande pour permettre la fixation de l'un de ceux-ci sur un substrat.

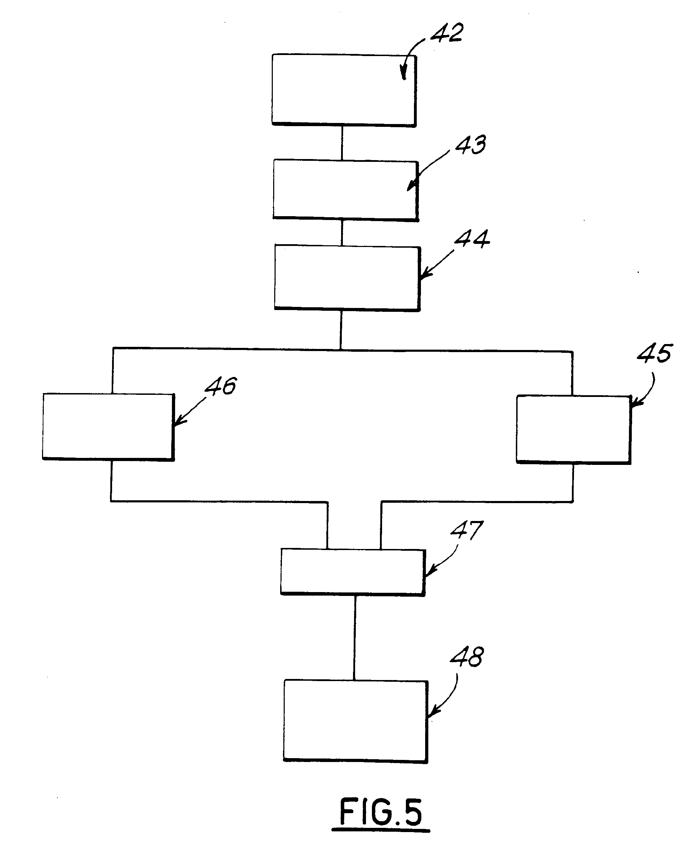

Comme on peut le voir sur la Fig.4 qui illustre une seconde partie d'un procédé de fabrication selon l'invention, la bande d'éléments de circuiterie 29 obtenue après découpe définitive des bandes de matériaux isolant et conducteur entre, en 34, dans le cycle décrit, en vue de son association avec un rouleau d'adhésif 35 et un substrat 36 fabriqué indépendamment de la circuiterie, comme mentionné précédemment.

En 37 et 38, la bande d'éléments de circuiterie ainsi que la bande d'adhésif 35 sont mises au format du substrat 36 et en 39, est prévue une étape de fixation d'un élément de circuiterie décrit précédemment et prélevé dans la bande 29, sur le substrat 36 par l'intermédiaire de l'adhésif 35. Une opération de polymérisation est prévue en 40 et un stockage en 41.

Dans le cas d'un circuit en trois dimensions dissipant de la puissance, c'est à dire que le substrat comporte un insert métallique intégré de moulage et faisant office de dispositif de dissipation de chaleur, le collage se fait de la même façon mais en remplaçant la feuille d'adhésif par un film plastique par exemple en polyimide comportant de la colle sur chaque face.

En effet, l'adhésif n'est pas un isolant suffisant si le matériau conducteur est collé en regard de l'insert.

Il est également à noter que dans le procédé décrit précédemment, le film isolant supportant la circuiterie doit servir de vernis épargne pour les opérations de report et de brasage des composants qui seront décrites plus en détail par la suite. C'est donc la partie de matériau conducteur qui est collée sur la face supérieure du substrat.

Sur la Fig.5, on a représenté une troisième partie du procédé de fabrication selon l'invention.

Le produit obtenu après la seconde partie du procédé selon l'invention est prêt à recevoir les composants pour montage en surface et réaliser ainsi un produit fini.

On part de l'étape 42, qui illustre le produit obtenu précédemment et comportant le substrat en combinaison avec la circuiterie.

En 43, est prévue une étape de sérigraphie de pâte à braser sur les plots de brasage de composants et en 44, est prévue la dépose des composants sur la circuiterie et le substrat.

Ensuite, en 45 ou 46, est prévu un brasage collectif de l'ensemble des composants par un procédé en phase vapeur ou en infrarouge avant une phase de nettoyage en 47 et l'obtention d'un produit fini en 48.

On conçoit donc que le substrat et la circuiterie sont réalisés indépendamment l'un de l'autre, la circuiterie étant elle-même réalisée en deux parties, une partie à partir d'une feuille de matériau conducteur et une autre à partir d'une feuille de matériau isolant. Ces deux feuilles sont découpées une première fois puis collées l'une sur l'autre et enfin découpées une deuxième fois afin d'obtenir une circuiterie adaptée pour être fixée sur le substrat par exemple par collage.

Ceci permet d'augmenter les cadences de fabrication de ce type de boîtiers dans la mesure où les différentes opérations décrites précédemment peuvent être réalisées indépendamment pour ce qui est de la fabrication du substrat et de la circuiterie et automatisées.

## Revendications

1. Procédé de fabrication d'un boîtier pour circuit électronique du type comportant un susbtrat (1), une circuiterie (9) d'interconnexion de composants électroniques (10), des moyens de connexion électrique (5,6) et des moyens de fixation (2) de ce boîtier sur un support de forme quelconque (4), caractérisé en ce que la circuiterie d'interconnexion des composants est réalisée indépendamment du substrat en opérant une première découpe d'une feuille de matériau conducteur (21) pour obtenir une ébauche de circuiterie, en fixant cette ébauche de circuiterie sur une feuille de matériau isolant (25), en opérant une deuxième découpe de cette ébauche et de cette feuille de matériau isolant pour obtenir la circuiterie d'interconnexion finale et enfin, en fixant cette circuiterie sur le substrat.

2. Procédé selon la revendication 1, caractérisé en ce que les feuilles de matériaux conducteur (21) et isolant (25) se présentent sous la forme de bandes dans lesquelles sont pratiqués lors de la première opération de découpe des trous d'indexation de position (23 ; 27), d'entraînement de bande (22 ; 26) ainsi que des découpes fonctionnelles (24 ; 28) délimitant dans la feuille de matériau conducteur, des portions conductrices, et dans la feuille de matériau isolant, des portions d'exposition de parties de la circuiterie.

3. Procédé selon la revendication 1 ou 2, caractérisé en ce que la fixation de l'ébauche de circuit sur la feuille de matériau isolant (25) est réalisée par collage.

4. Procédé selon l'une quelconque des revendications précédentes, caractérisé en ce que la fixation de la circuiterie sur le substrat est réalisée par collage.

5. Procédé selon l'une quelconque des revendications précédentes, caractérisé en ce qu'après collage de la circuiterie d'interconnexion sur le substrat on fixe les composants (10) sur la circuiterie d'interconnexion.

6. Procédé selon l'une quelconque des revendications précédentes, caractérisé en ce que le substrat (1) comporte des inserts métalliques entrant dans la constitution de connecteurs d'entrée et de sortie (5, 6) du boîtier et d'un dissipateur thermique (7) et en ce qu'une feuille de polyimide est interposée entre la circuiterie et le substrat.

7. Procédé selon l'une quelconque des revendications précédentes, caractérisé en ce que la circuiterie est fixée sur le substrat avec la face de matériau conducteur tournée vers le substrat, la face de matériau isolant de celle-ci faisant fonction de vernis épargne.

## Patentansprüche

1. Verfahren für die Herstellung eines Gehäuses für eine elektronische Schaltung umfassend ein Substrat (1), einen Verbindungsschaltkreis (9) für elektronische Komponenten (10), Mittel (5, 6) für den elektrischen Anschluß und Mittel (2) für die Befestigung dieses Gehäuses auf einer Unterlage (4) beliebiger Form,
**dadurch gekennzeichnet, daß** der Verbindungsschaltkreis für die Komponenten unabhängig von dem Substrat hergestellt wird, indem man einen ersten Zuschnitt einer Folie aus leitendem Material (21) durchführt, um einen Rohling eines Verbindungsschaltkreises zu erhalten und dieser Rohling des Verbindungsschaltkreises auf einer Folie aus isolierendem Material (25) befestigt wird, und daß man einen zweiten Zuschnitt dieses Rohlings und der Folie aus isolierendem Material durchführt, um den endgültigen Verbindungsschaltkreis zu erhalten und dieser Verbindungsschaltkreis auf dem Substrat befestigt wird.

2. Verfahren nach Anspruch 1,
**dadurch gekennzeichnet, daß** die Folien aus leitendem Material (21) und aus isolierendem Material (25) die form von Streifen haben, in die während dem ersten Zuschnitt Indexierungslöcher für die Position (23; 27), sowie für die Mitnahme des Streifens (22 ; 26) und funktionelle Ausschnitte (24 ; 28) eingebracht werden, welche in der Folie aus leitendem Material leitende Abschnitte und in der Folie aus isolierendem Material freiliegende beschnitte für die Teile des Verbindungsschaltkreises bilden.

3. Verfahren nach einem der Ansprüche 1 oder 2,
**dadurch gekennzeichnet, daß** die Befestigung des Rohlings des Schaltkreises auf der Folie aus isolierendem Material (25) durch Verklebung erfolgt.

4. Verfahren nach einem der vorausgegangenen Ansprüche,
**dadurch gekennzeichnet, daß** die Befestigung des Verbindungsschaltkreises auf dem Substrat durch Verklebung erfolgt.

5. Verfahren nach einem der vorausgegangenen Ansprüche,
**dadurch gekennzeichnet, daß** nach der Verklebung der Verbindungsschaltkreis auf dem Substrat die Komponenten (10) auf dem Verbindungsschaltkreis befestigt werden.

6. Verfahren nach einem der vorausgegangenen Ansprüche,
**dadurch gekennzeichnet, daß** das Substrat (1) metallische Einsätze trägt, die Teil des Aufbaus von Eingangssteckern (5) und Ausgangssteckern (6) des Gehäuses und eines Kühlkörpers (7) sind, und dadurch, daß zwischen dem Verbindungsschaltkreis und dem Substrat eine Folie aus Polyimid eingelegt ist.

7. Verfahren nach einem der vorausgegangenen Ansprüche,
**dadurch gekennzeichnet, daß** der Verbindungsschaltkreis auf dem Substrat so befestigt ist, daß die Oberfläche des leitenden Materials gegen das Substrat gekehrt ist und die Oberfläche des isolierenden Materials die Funktion eines Abdecklackes erfüllt.

## Claims

1. Method for manufacturing a housing for an electronic circuit of the type having a substrate (1), circuitry (9) for connecting electronic components (10), means for electrical connection (5, 6) and means (2) for firing this housing to a support (4) of any shape, characterised in that the circuitry for connecting the components is produced independently of the substrate by effecting a first cutting of a sheet of conductive material (21) to obtain an outline for the circuitry, firing this circuitry outline to a sheet of insulating material (25), effecting a second cutting of this outline and sheet of insulating material in order to obtain the final connecting circuitry and finally firing this circuitry to the substrate.

2. Method according to Claim 1, characterised in that the sheets of conductive (21) and insulating (25) material are in the form of strips in which are made, at the time of the first cutting operation, strip position indexing (23; 27) and driving holes (22; 26), as well as functional cuts (24; 28) determining, in the sheet of conductive material, conductive portions, and, in the sheet of insulating material, portions for exposing parts of the circuitry.

3. Method according to Claim 1 or 2, characterised in that the firing of the circuitry outline to the sheet of insulating material (25) is effected by bonding.

4. Method according to any one of the preceding claims, characterised in that the firing of the circuitry to the substrate is effected by bonding.

5. Method according to any one of the preceding claims, characterised in that, after bonding the connection circuitry to the substrate, the components (10) are fired to the connecting circuitry.

6. Method according to any one of the preceding claims, characterised in that the substrate (1) includes metal inserts forming part of input and output connectors (5, 6) on the housing and a heat dissipator (7), and in that a sheet of polyimide is interposed between the circuitry and substrate.

7. Method according to any one of the preceding claims, characterised in that the circuitry is fired to the substrate with the conductive material face turned towards the substrate, the insulating material face of the circuitry serving as a resist varnish.
